# EUROPEAN PATENT APPLICATION

(11) **EP 2 073 614 A2**
(43) Date of publication of application: **24.06.2009**
(21) Application number: 08254002.2
(22) Date of filing: 15.12.2008
(51) Int. Cl.: H05K 3/30

(54) **Contact and connecting device**

(30) Priority: 17.12.2007 JP 2007325011
(71) Applicant: Hosiden Corporation, Yao-shi, Osaka 581-0071 (JP)
(72) Inventor: Ohmori, Yasuhiro, Yao-shi Osaka 581-0071 (JP)
(74) Representative: Beresford, Keith Denis Lewis

(57) **Abstract**

An object of the present invention is to provide a contact and a connecting device capable of stably connecting and supporting an electronic component such as a cold cathode fluorescent lamp in midair.

A contact 200 for connection with a cold cathode fluorescent lamp 10 includes a base part 210, a supporting part 220 that is provided on top of the base part 210 for supporting a lead terminal 12 of a cold cathode fluorescent lamp 10, and at least two clamp parts 230 that are provided on top of the base part 210 so as to be located on respective outer sides of the supporting part 220. The clamp parts 230 are adapted to sandwich the lead terminal 12 of the lamp 10 between themselves and the supporting part 220. Alternatively, the clamp parts 230 may be adapted to sandwich part of an adapter for the lead terminal.

## Description

The present invention relates to a contact and a connecting device for connecting an electronic component such as a cold cathode fluorescent lamp.

A known contact of this type has a pair of clamp pieces that sandwiches a cap-like adapter covering an end part of a cold cathode fluorescent lamp, as disclosed in Japanese Utility Model Application Laid-Open No. 64-48851. Another known contact has a mounting base on which the adapter is mounted, and a pair of clamp pieces that sandwiches the adapter on the mounting base, as disclosed in Japanese Patent Application Laid-Open No. 2006-351529.

In the former known contact, the clamp pieces sandwich the adapter and support the same in midair. If the cold cathode fluorescent lamp is under vibrating conditions or the like, the connection between the connector and the cold cathode fluorescent lamp may become unstable.

On the other hand, in the latter contact, because the clamp pieces sandwich the adapter on the mounting base, the connection between the connector and the cold cathode fluorescent lamp is more stable than that of the former contact. However, it is required to separately provide a pedestal for mounting the contact itself in order to support the cold cathode fluorescent lamp in midair.

The present invention is devised in light of the above-described situations. An embodiment of the invention provides a contact and a connecting device capable of stably connecting and supporting an electronic component such as a cold cathode fluorescent lamp in midair.

In order to solve the above-described problems, the present invention provides a contact for connection with an electronic component. The contact includes: a base part; a supporting part, provided on top of the base part for supporting a lead terminal of the electronic component; and at least two clamp parts, provided on top of the base part so as to be located on respective outer sides of the supporting part. The clamp parts are adapted to sandwich the lead terminal of the electronic component between themselves and the supporting part.

In this contact, the supporting part and the clamp parts are provided on top of the base part, so that the lead terminal of the electronic component is supported in midair by the supporting part and is sandwichingly held by the clamp parts and the supporting part. Thus, the contact can stably connect the electronic component thereto and support it in midair.

The base part is preferably a plate-like body substantially of a U shape in planar view or substantially O shape in planar view, the base part including a first plate and two second plates continuous with respective ends of the first plate and bent toward the same direction. In this case, the supporting part may be a plate-like body extending from an upper end of the first plate and being bent toward the same direction as the second plates, and the clamp parts may be a plate-like body extending upward from respective upper ends of the second plates.

In this case, when the lead terminal of the electronic component is inserted between the clamp parts, the lead terminal is sandwiched between the clamp parts and the supporting part. This configuration significantly eases the attachment and removal of the lead terminal. Further, the base part has a substantially U shape in planar view or a substantially O shape in planar view, so that the base part can be stably set on a setting portion of the electronic equipment such as the circuit board. Therefore, the base part is advantageous in stably connecting and supporting the electronic component in midair. Moreover, the base part, the supporting part and the clamp parts, being plate bodies provided integrally, can be easily manufactured by press-molding or other processing, which leads to reduction in the cost of the contact.

In the case where the contact is of a circuit board mounting type, the contact can further include at least one of a contacting part and a locking part, the contacting part being a plate-like body extending downward from a lower end of the base part and being connectable to the circuit board, the locking part being a plate-like body extending downward from the lower end of the base part and being lockable in the circuit board. In this case, a lower end face of the base part is abuttable against the circuit board, in at least one of states where the contacting part is connected to circuit board and where the locking part is locked in the circuit board.

In this manner, in the state where the contacting part is connected to the circuit board and/or in the state where the locking part is locked in the circuit board, the lower end face of the base part abuts the circuit board, which allows stable setting of the contact on the circuit board upon connecting and/or locking the contact to the circuit board.

Preferably, the contacting part extends from a lower end of the first plate of the base part, and the locking part extends downward from a lower end of one of the second plates of the base part. In this case, a lower end face of the base part abuts the circuit board when the contacting part is connected to the circuit board and the locking part is locked in the circuit board.

In this case, upon connecting the contacting part to the circuit board by soldering or other means and locking the locking parts in the circuit board, the base part is attached to the circuit board at least three points. The base part is stably set on the circuit board in this state, so that the electronic component can be advantageously connected and supported in midair in a stable manner.

A first connecting device of the present invention is adapted for connection with an electronic component, the electronic component having a main body and a lead terminal provided on an end part of the main body and extending in a length direction of the main body. The connecting device includes an adapter for connection with the electronic component, and the contact described above that is connectable to the electronic component via the adapter. The adapter includes a first connecting part, electrically and mechanically connectable to the lead terminal of the electronic component; a second connecting part, arranged so as to face the end part of the main body of the electronic component; and an elastically deforming part, provided between the first and second connecting parts and elastically deformable in accordance with thermal expansion or thermal contraction in the length direction of the electronic component. The supporting part may be adapted to support the second connecting part, instead of the lead terminal of the electronic component, while the clamp parts may be adapted to sandwich the second connecting part, instead of the lead terminal of the electronic component, between themselves and the supporting part.

In the above first connecting device, when the electronic component is thermally expanded or thermally contracted in the state where the first connecting part of the adapter is connected to the lead terminal, and where the second connecting part of the adapter is sandwiched between the clamp parts and the supporting part of the contact, the elastically deforming part is elastically deformed in the length direction of the electronic component. This elastic deformation absorbs the thermal expansion or the thermal contraction of the electronic component. Therefore, it is possible to reduce load on the lead terminal and the main body of the electronic component connected to the first connecting part of the adapter due to the thermal expansion or the thermal contraction of the electronic component.

The clamp parts can be formed so as to have abutting parts, bent inward and adapted to sandwich the lead terminal of the electronic component between themselves and the supporting part by elastically abutting the lead terminal, and inclined parts, continued from upper ends of the abutting parts and inclined outward. In this case, it is preferable that a distance between upper ends of the inclined parts is larger than a width dimension of the lead terminal of the electronic component, and a distance between tops of the abutting parts is smaller than the width dimension.

In this case, when the lead terminal of the electronic component is inserted between the inclined parts, the abutting parts are pressed by the lead terminal, so that the clamp parts are elastically deformed to be displaced outward. Once the lead terminal climbs over the abutting parts, the clamp parts are displaced inward, i.e. in the returning directions. The abutting parts thus abut the lead terminal and sandwich the lead terminal between themselves and the supporting part. As described above, the inclined parts at the upper end of the clamp parts are inclined outward, and the distance therebetween is larger than the width dimension of the lead terminal.

Consequently, the invention in this aspect can prevent damage to the lead terminal by the upper ends of the clamp parts during the insertion or similar troubles.

A second connecting device of the present invention is for connection with an electronic component, the electronic component having a main body and a lead terminal provided on an end part of the main body and extending in a length direction of the main body. The connecting device includes an adapter for connection with the electronic component, and the contact described above that is connectable to the electronic component via the adapter. The adapter has a first connecting part, electrically and mechanically connectable to the lead terminal of the electronic component; a second connecting part, arranged so as to face the end part of the main body of the electronic component; and an elastically deforming part, provided between the first and second connecting parts and elastically deformable in accordance with thermal expansion or thermal contraction in the length direction of the electronic component. The supporting part of the contact may be adapted to support the second connecting part, instead of the lead terminal of the electronic component, while the abutting parts of the clamp parts may be adapted to abut the second connecting part, instead of the lead terminal of the electronic component, so as to sandwich the second connecting part between themselves and the supporting part. In this second connective device, the distance between the upper ends of the inclined parts may be larger than a width dimension of the second connecting part (as opposed to being larger than the width dimension of the lead terminal of the electronic component), while the distance between the tops of the abutting parts may be smaller than the width dimension of the second connecting part (as opposed to being smaller than the width dimension of the lead terminal part of the electronic component).

In the above second connecting device, when the second connecting part of the adapter is inserted between the inclined parts, the abutting parts are pressed by the second connecting part, so that the clamp parts are elastically deformed to be displaced outward. Once the second connecting part climbs over the abutting parts, the clamp parts are displaced inward, i.e. in the returning directions. The abutting parts thus abut the second connecting part and sandwich the second connecting part between themselves and the supporting part. As described above, the inclined parts at the upper end of the clamp parts are inclined outward, and the distance therebetween is larger than the width dimension of the second connecting part. Consequently, the invention in this aspect can prevent damage or similar troubles to the second connecting part by the upper ends of the clamp parts during the insertion. Additionally, if the electronic component is thermally expanded or thermally contracted in the state where the first connecting part of the adapter is connected to the lead terminal and the second connecting part of the adapter is sandwiched by the clamp parts and the supporting part of the contact, the elastically deforming part is elastically deformed in the length direction of the electronic component. This elastic deformation absorbs the thermal expansion or the thermal contraction of the electronic component. Therefore, it is possible to reduce load on the lead terminal and the main body of the electronic component connected to the first connecting part of the adapter due to the thermal expansion or the thermal contraction of the electronic component.

The contact may further have at least two holding parts that extend upward from the upper ends of the second plates of the base part and are adapted to sandwich the end part of the main body of the electronic component.

The holding parts to hold the main body of the electronic component in the above manner can suppress vibration of the electronic component or the like. It is thus possible to prevent excessive load on the entire electronic component due to such vibrations, and to prevent some portion of the electronic component from colliding with the adapter due to vibrations.

Each of the holding parts can be shaped so as to have a holding body, bent outward conforming to an outer shape of the main body of the electronic component, and an inclined portion, continuous to an upper end of the holding body and inclined outward. In this case, it is preferable that a distance between upper ends of the inclined portions is larger and a distance between lower ends of the inclined portions is smaller than a width dimension of the main body of electronic component.

More specifically, when the main body of the electronic component is inserted between the inclined parts of the holding parts, the lower end parts of the inclined parts are pressed by the main body, so that the holding parts are elastically deformed to be displayed outward. Once the main body climbs over the lower end parts of the inclined parts, the holding parts displaced inward, i.e. in the returning directions. This allows the holding part bodies to sandwich the main body. As described above, the inclined parts at the upper end of the holding parts are inclined outward, and the distance therebetween is larger than the width dimension of the main body of the electronic component. Consequently, the invention in this aspect can prevent damage or similar troubles to the main body by the upper ends of the holding parts during insertion.

It is preferable that the second connecting part is an annular body adapted to receive the end part of the main body of the electronic component. Such an annular second connecting part is easier to be sandwichingly held between the clamp parts and the supporting part of the contact.

The invention will now be described by way of example only with reference to the drawings in which:
Fig. 1 is a perspective view illustrating a lamp connecting state of a connecting device according to an embodiment of the present invention;
Fig. 2 illustrates the lamp connecting state of the same device, wherein Fig. 2(a) is a front view and
Fig. 2(b) is a back view;
Fig. 3 illustrates the lamp connecting state of the same device, wherein Fig. 3(a) is a plan view and Fig. 3(b) is a side view;
Fig. 4 illustrates an adapter of the same device, wherein Fig. 4 (a) is a side view and Fig. 4(b) is a front view;
Fig. 5 perspectively illustrates a contact of the same device, wherein Fig. 5(a) is a view seen from a front upper side and Fig. 5(b) is a view seen from a back upper side;
Fig. 6 illustrates the lamp connecting state of the same device in plan view, wherein Fig. 6(a) illustrates an initial state, Fig. 6(b) illustrates a state where the cold cathode fluorescent lamp is thermally expanded and an elastically deforming part of the adapter is extended, and Fig. 6(c) illustrates a state where the cold cathode fluorescent lamp is thermally contracted and the elastically deforming part of the adapter is contracted;
Fig. 7 illustrates a first design modification of the adapter, wherein Fig. 7(a) is a side view, and 7(b) is a perspective view of a state where the adapter is connected to the cold cathode fluorescent lamp;
Fig. 8 illustrates a second design modification of the adapter, wherein Fig. 8(a) is a perspective view, and Fig. 8(b) is a side view of a state where the adapter is connected to the cold cathode fluorescent lamp;
Fig. 9(a) is a perspective view illustrating a third design modification of the adapter, and Fig. 9(b) is a perspective view illustrating a fourth design modification of the adapter;
Fig. 10 is a perspective view illustrating a first design modification of the contact in a state where the adapter and the cold cathode fluorescent lamp are connected to each other; and
Fig. 11 is perspective views illustrating a second design modification of the contact, wherein Fig. 11(a) is a view seen from a front upper side, and Fig. 11(b) is a view seen from a back upper side.

### DESCRIPTION OF THE REFERENCE NUMERALS

10 Cold cathode fluorescent lamp (electronic component)
   11 Lamp body (main body)
   12 Lead terminal
20 Circuit board
   21 Locking hole
   22 Through-hole
100 Adapter
   110 First connecting part
   120 Second connecting part
   130 Elastically deforming part
200 Contact
   210 Base part
   220 Supporting part
   230 Clamp part
      232 Abutting part
      233 Inclined part
   240 Holding part
      242 Holding body
      243 Inclined portion
   250 Contacting part
   260 Locking part

In the description which follows, relative spatial terms such as "upper", "lower", "upward", "downward", "top", etc., are used for the convenience of the skilled reader and refer to the orientation of the contact and/or connecting device and their constituent parts as depicted in the drawings. No limitation is intended by use of these terms, either in use of the invention, during its manufacture, shipment, custody, or sale, or during assembly of its constituent parts or when incorporated into or combined with other apparatus.

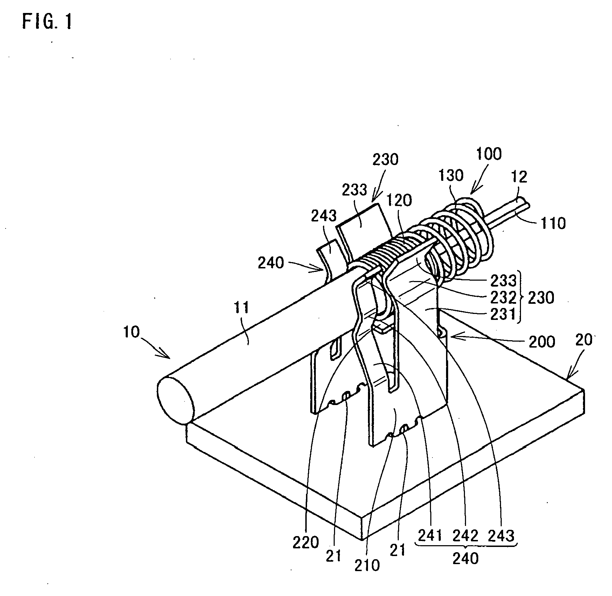

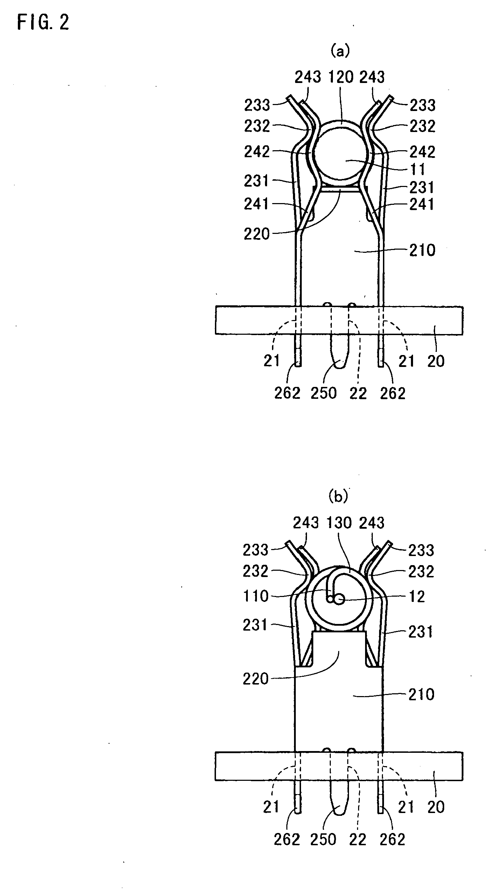

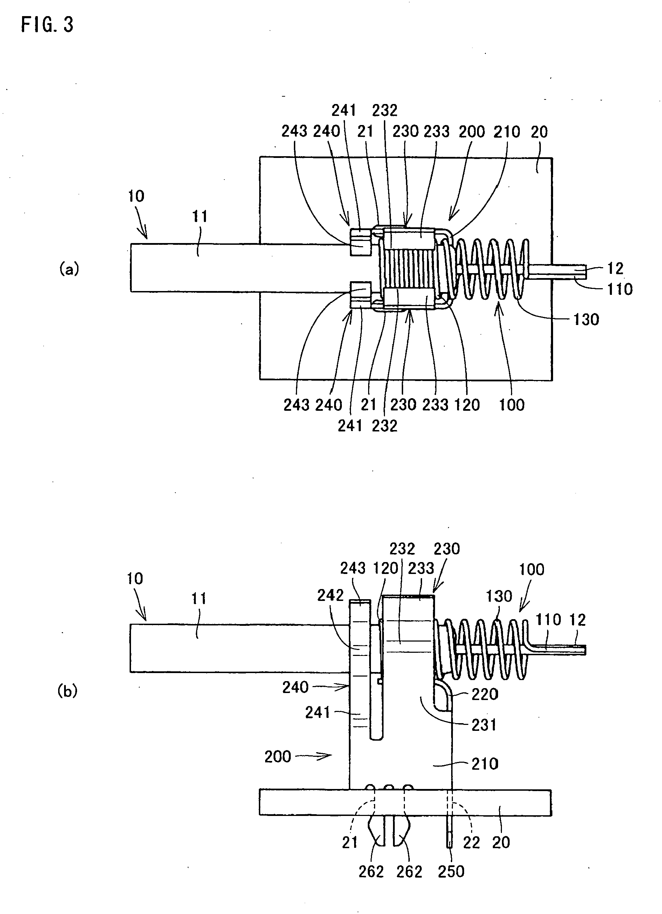

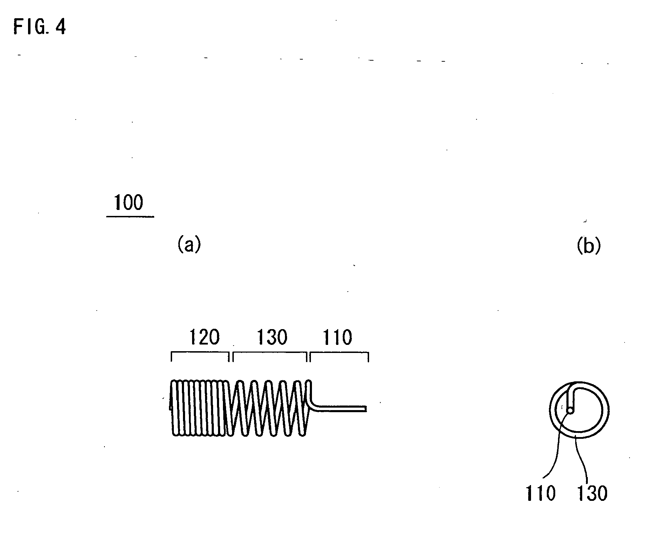

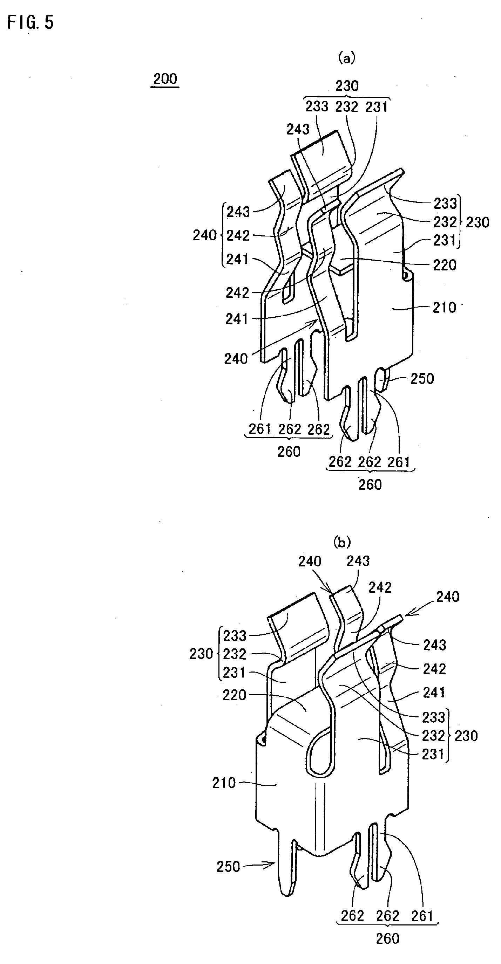

A connecting device using a contact according to an embodiment of the present invention will be described below with reference to Figs. 1 to 6.

The connecting device illustrated in Figs. 1 to 3 includes an adapter 100 to be connected to a lead terminal 12 of a cold cathode fluorescent lamp 10 (electronic component), and a contact 200 to be connected to the cold cathode fluorescent lamp 10 via the adapter 100 and mounted on a circuit board 20 of electronic equipment (not shown). Details of these elements will be described below.

The cold cathode fluorescent lamp 10 includes a lamp body 11 and a pair of lead terminals 12 (only one shown). The pair of lead terminals 12 is provided on respective end parts in the length direction of the lamp body 11 and extend in the length direction. For convenience of illustration, only one end part of the lamp body 11 is illustrated in Figs. 1 to 3 and Fig. 6.

The adapter 100 is a coil spring having conductivity as illustrated in Figs. 1 to 4. The adapter 100 includes a first connecting part 110, electrically and mechanically connected to the lead terminal 12 of the cold cathode fluorescent lamp 10, a second connecting part 120, arranged so as to face the one end part of the lamp body 11 of the cold cathode fluorescent lamp 10, and an elastically deformable part 130, provided between the first and second connecting parts 110, 120, and elastically deformable in accordance with thermal expansion or thermal contraction in the length direction of the cold cathode fluorescent lamp 10.

The second connecting part 120 is an end turn portion of the coil spring. An inner diameter of the second connecting part 120 is slightly larger than an outer diameter of the lamp body 11 of the cold cathode fluorescent lamp 10. That is, a base end portion of the one end part of the lamp body 11 can be inserted into the second connecting part 120. When the one end part of the lamp body 11 is inserted into the second connecting part 120, the second connecting part 120 will be arranged to face the one end part.

The elastically deformable part 130 is a coil spring portion of the coil spring that continues to an end of the second connecting part 120, and whose coil intervals are larger than those of the second connecting part 120. The elastically deformable part 130 is set to have such a level of spring force as not to apply load to the cold cathode fluorescent lamp 10 during extension or contraction, particularly to the lead terminal 12 and a part of the lamp part 11 sealing the lead terminal 12. Moreover, an inner diameter of the elastically deformable part 130 is substantially the same as the inner diameter of the second connecting part 120. This allows a distal portion of the end part of the lamp body 11 and a base end portion of the lead terminal 12 to be inserted into the elastically deformable part 130.

The first connecting part 110 is a substantially L-shaped rod-like body. The first connecting part 110 has a basal part that continues to an end part of the elastically deformable part 130 and is bent toward a center of the coil spring, and a distal part that continues to the basal part and is bent at a right angle toward the one lengthwise end. This distal part of the first connecting part 110 is electrically and mechanically connected to a distal portion of the lead terminal 12 by soldering, welding or other means.

The adapter 100 configured as described above is connected to the cold cathode fluorescent lamp 10 in the following steps. First, the end part of the lamp body 11 and the lead terminal 12 of the cold cathode fluorescent lamp 10 are inserted into the second connecting part 120 and then into the elastically deformable part 130 of the adapter 100 to bring the distal portion of the lead terminal 12 into abutment against the distal part of the first connecting part 110. Consequently, the distal portion of the end part of the lamp body 11 and the base end portion of the lead terminal 12 are disposed inside of the elastically deformable part 130, and the basal portion of the end part of the lamp body 11 is disposed inside the second connecting part 120.

Thereafter, the lead terminal 12 of the cold cathode fluorescent lamp 10 and the distal part of the first connecting part 110 are electrically and mechanically connected by soldering, welding or any other means. In the above steps, the adapter 100 is electrically and mechanically connected to the cold cathode fluorescent lamp 10.

The circuit board 20, a well-known printed circuit board, has two locking holes 21 and a through-hole 22. The locking holes 21 and the through-hole 22 are long elliptical holes penetrating the circuit board 20 in a thickness direction thereof.

The contact 200 is formed by press-molding a metal plate having conductivity. As illustrated in Figs. 1 to 3 and Fig. 5, the contact 200 includes a base part 210 having a substantially U shape in planar view, a supporting part 220 extended from an upper end of an intermediate part (first plate) of the base part 210, two clamp parts 230 extended upward from respective upper ends on the basal sides of outer parts (second plates) of the base part 210, and two holding parts 240 extended upward from respective upper ends on the distal sides of the outer parts of the base part 210, a contacting part 250 extended downward from a lower end of the intermediate part of the base part 210, and two locking parts 260 extended downward from lower ends of the outer parts of the base part 210, respectively.

The base part 210 consists of the intermediate part, which is a substantially rectangular plate body, and the outer parts, which continue to opposite ends of the intermediate part and are respectively bent substantially at a right angle with respect to the intermediate part. The outer parts of the base part 210 each have the basal side portion, which is a substantially rectangular plate body of the same height as that of the intermediate part, and the distal side portion, which is a substantially rectangular plate body continuous with a lower end part of the basal side portion.

The supporting part 220 is a plate body having a substantially L shape turned 90 degrees in side view and being bent toward the same direction as that of the outer parts of the base part 210. The supporting part 220 consists of a vertical part continuing to the upper end of the intermediate part of the base part 210, and a horizontal part continuing to an upper end of the vertical part and bent substantially at a right angle with respect to the vertical part. The horizontal part is adapted to receive thereon, in use, the second connecting part 120 of the adapter 100 together with the lamp body 11 of the cold cathode fluorescent lamp 10. The horizontal part has a length dimension slightly larger than a length dimension of the basal end portions of the outer parts of the base part 210. This length is set not to interfere with bent parts 241 of the holding parts 240 on the distal side of the outer parts of the base part 210.

Each of the clamp parts 230 is a plate body having slightly smaller width dimension than a length dimension of the corresponding basal side portion of the outer part of the base part 210. Each clamp part 230 consists of an extended part 231 continuing to the upper end of the basal side portion, an abutting part 232 continuing to an upper end of the extended part 231, and an inclined part 233 continuing to an upper end of the abutting part 232.

The extended parts 231 are straight plates extending from the respective basal side portions of the outer parts of the base part 210 so as to be disposed lateral to the supporting part 220. The abutting parts 232 are plates bent inward into a V shape. The inclined parts 233 are plates bent so as to be inclined outward.

A distance between upper ends of the inclined parts 233 is larger than a diameter (i.e., width dimension) of the second connecting part 120 of the adapter 100. A distance between top parts of the abutting parts 232 is smaller than the diameter of the second connecting part 120. Thus, when the second connecting part 120 is inserted between the inclined parts 233, the abutting parts 232 are pressed by the second connecting part 120, and the clamp parts 230 are elastically deformed to be displaced outward. Once the second connecting part 120 climbs over the abutting parts 232, more specifically, past an apex of the abutting parts 232, the clamp parts 230 are displaced inward, i.e., in return direction by the resilience of the contact. As a result, the abutting parts 232 abut against the second connecting part 120 from oblique upper directions and sandwich the second connecting part 120 between themselves and the supporting part 220. Setting the distance between the upper ends of the inclined parts 233 to be larger than the diameter of the second connecting part 120 of the adapter 100 prevents the upper ends of the inclined parts 233 from damaging the second connecting part 120 when the second connecting part 120 is inserted between the inclined parts 233.

Each of the holding parts 240 is plate-like and consists of the aforementioned bent part 241 continuous with an upper end of the corresponding distal side portion of the outer part of the base part 210, a holding body 242 continuous with an upper end of the bent part 241, and an inclined portion 243 continuous with an upper end of the holding body 242.

The bent parts 241 are generally straight-plate-like and bent so as to be inclined inward. The holding bodies 242 are plate-like and bent outward into circular arc shapes conforming to an outer shape of the lamp body 11 of the cold cathode fluorescent lamp 10. The inclined portions 243 are generally straight-plate-like and bent so as to be inclined outward.

A distance between upper ends of the inclined portions 243 is larger than a diameter (i.e., width dimension) of the lamp body 11, and a distance between lower ends of the inclined portions 243 is smaller than the diameter of the lamp body 11. Thus, when the lamp body 11 is inserted between the inclined portions 243, lower end parts of the inclined portions 243 are pressed, and the holding parts 240 are elastically deformed to be displaced outward. Once the lamp body 11 climbs over or passes the lower end parts of the inclined portions 243, the holding parts 240 are displaced inward, i.e., in return direction. As a result, the holding bodies 242 sandwich the lamp body 11. Setting the distance between the upper ends of the inclined portions 243 to be larger than the diameter of the lamp body 11 prevents the upper ends of the inclined portions 243 from damaging the lamp body 11 when the lamp body 11 is inserted between the inclined portions 243.

The contacting part 250 is a straight plate body whose opposite corners on a distal side are cut out. The contacting part 250 is adapted to be inserted into the through-hole 22 of the circuit board 20 for electrical connection.

The locking parts 260 each consists of an elastically deformable arm part 261 of substantially reverse U-shaped, and a pair of locking claws 262 that are provided on distal end portions of the arm part 261 and are projected outward.

The locking claws 262 are inserted into the associated locking hole 21 of the circuit board 20 so as to be locked against lower surfaces of opposite lengthwise edges of the locking holes 21. The locking claws 262 as locked serve to attach the contact 200 onto the circuit board 20.

Length dimensions of the basal end portions of the arm part 261 are substantially the same as a thickness dimension of the circuit board 20. Thus, in a state where the locking claws 262 are locked against the edges of the locking hole 21 of the circuit board 20, a lower end face of the base part 210 abuts against the circuit board 20.

The contact 200 having the above-described configuration is mounted on the circuit board 20 in the following manner. First, the two locking parts 260 of the contact 200 are positioned and inserted into the two locking holes 21 of the circuit board 20. Then, the pairs of locking claws 262 of the locking parts 260 are pressed against respective upper ends of the edges of the locking holes 21, so that the distal portions of the arm parts 261 of the locking parts 260 are elastically deformed inward.

Once the pairs of locking claws 262 of the locking parts 260 climb over or pass the edges of the locking holes 21, the distal parts of the arm parts 261 of the locking parts 260 are elastically deformed outward. The locking claws 262 are thus locked against the lower surfaces of the edges of the locking holes 21. Consequently, the lower end face of the base part 210 abuts the circuit board 20. In the above manner, the contact 200 is attached onto the circuit board 20.

In the meantime, the contacting part 250 of the contact 200 is inserted into the through-hole 22 of the circuit board 20. The contact 200 is thereby electrically connected to the circuit board 20.

The following is a description of steps for connecting the adapter 100 to the contact 200 mounted on the circuit board 20. The adapter 100 is connected with the cold cathode fluorescent lamp 10 in advance as described above.

First, the second connecting part 120 of the adapter 100 is pushed into a space between the inclined parts 233 of the two clamp parts 230 of the contact 200, and the end part of the lamp body 11 of the cold cathode fluorescent lamp 10 is pushed into a space between the inclined portions 243 of the two holding parts 240 of the contact 200.

The clamp parts 230 are thus pressed by the second connecting part 120 at the abutting parts 232 thereof, so that the clamp parts 230 are elastically deformed to be displaced outward. Once the second connecting part 120 climbs over the abutting parts 232, the clamp parts 230 are displaced inward, i.e. in the returning directions. The abutting parts 232 thus abut the second connecting part 120 from the oblique upper directions, and sandwich the second connecting part 120 between the supporting part 220 and themselves.

In the meantime, the lower end parts of the inclined portions 243 are pressed by the lamp body 11, so that the holding parts 240 are elastically deformed to be displaced outward. Once the lamp body 11 climbs over the lower end parts of the inclined portions 243, the holding parts 240 are displaced inward, in the returning directions. Thereby, the holding part bodies 242 sandwich the lamp body 11. In the above manner, the cold cathode fluorescent lamp 10 and the adapter 100 are supported in midair by the contact 200, and the cold cathode fluorescent lamp 10 is electrically connected to the contact 200 via the adapter 100.

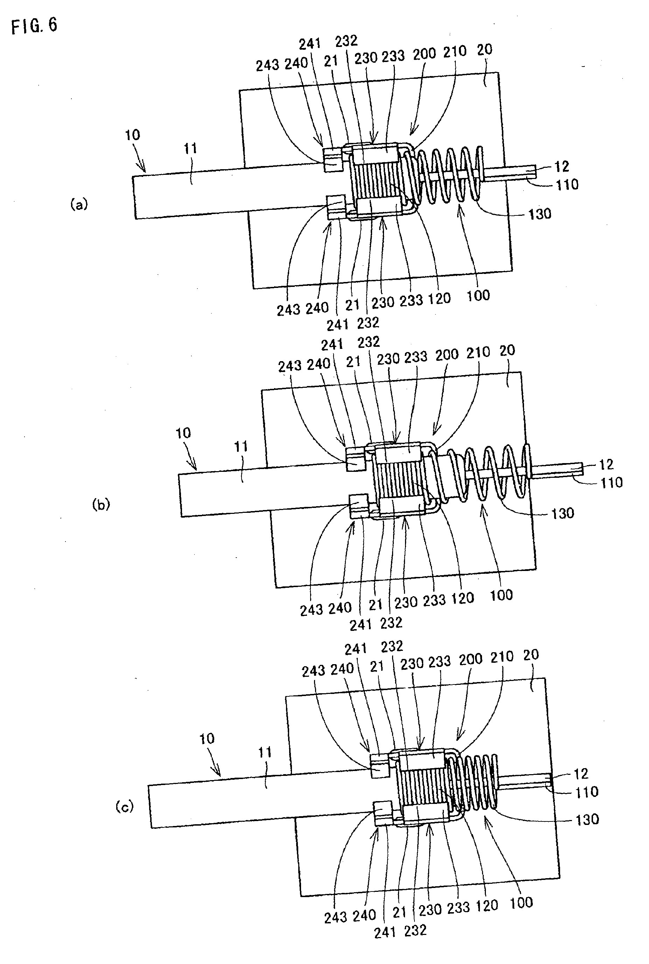

If the cold cathode fluorescent lamp 10 is thermally expanded in its length direction as illustrated in Fig. 6(b) in the state where the adapter 100 and the cold cathode fluorescent lamp 10 are connected to the contact 200, the elastically deformable part 130 of the adapter 100 is extended, so that the first connecting part 110 of the adapter 100 moves in the length direction, to the right in the figure, together with the lead terminal 12 of the cold cathode fluorescent lamp 10.

On the other hand, as illustrated in Fig. 6(c), when the cold cathode fluorescent lamp 10 is thermally contracted in its length direction, the elastically deformable part 130 of the adapter 100 is contracted, so that the first connecting part 110 of the adapter 100 moves in the length direction, to the left in the figure, together with the lead terminal 12 of the cold cathode fluorescent lamp 10.

During the movement of the first connecting part 110, the second connecting part 120 of the adapter 100, sandwiched by the two clamp parts 230 of the contact 200, does not move in its length direction in accordance with the thermal expansion or the thermal contraction of the lamp body 11 of the cold cathode fluorescent lamp 10.

In the above manner, the elastic deformation of the elastically deformable part 130 of the adapter 100 absorbs the thermal expansion or the thermal contraction of the cold cathode fluorescent lamp 10.

The cold cathode fluorescent lamp 10 and the adapter 100 may be removed from the contact 200 in the following steps. First, the cold cathode fluorescent lamp 10 is lifted upward. Then, the abutting parts 232 of the clamp parts 230 are each pressed by the second connecting part 120 of the adapter 100, so that the clamp parts 230 are elastically deformed to be displaced outward. Thereafter, once the second connecting part 120 climbs over the abutting parts 232, the second connecting part 120 can be taken out from the space between the inclined parts 233 of the clamp parts 230. The clamp parts 230 are then displaced inward, in the returning directions.

In the meantime, the respective upper ends of the holding part bodies 242 of the contact 200 are pressed by the lamp body 11 of the cold cathode fluorescent lamp 10, so that the holding parts 240 are elastically deformed to be displaced outward. Once the lamp body 11 climbs over the upper ends of the holding part bodies 242, the lamp body 11 can be taken out from the space between the inclined portions 243 of the holding parts 240. Thereafter, the holding parts 240 is displaced inward in a returning manner. In the above steps, the cold cathode fluorescent lamp 10 and the adapter 100 can be easily removed from the contact 200.

The connecting device described above has the following advantages. Particularly, the device can be securely set on the circuit board 20 by bringing the lower edge of the base part 210 having a substantially U shape in planar view of the contact 200 into abutment against the circuit board 20. Moreover, the contact 200 of the connecting device stably connects to and holds the cold cathode fluorescent lamp 10 in midair. This is because the supporting part 220 and the clamp parts 230 provided at the upper end of the base part 210 sandwich the second connecting part 120 of the adapter 100 together with the cold cathode fluorescent lamp 10. Moreover, vibrations of the lamp body 11 and the like can be suppressed because the holding parts 240 of the contact 200 sandwich the lamp body 11 of the cold cathode fluorescent lamp 10. Consequently, it is possible to avoid overload on the entire cold cathode fluorescent lamp 10 due to such vibrations, and possible to prevent some portion of the cold cathode fluorescent lamp 10 from colliding with the adapter.

Additionally, the contact 200, being a press-molded article, can be produced at low cost. Accordingly, the connecting device is advantageous in reducing the cost.

Furthermore, through elastic deformation of the elastically deformable part 130, the adapter 100 can absorb thermal expansion or thermal contraction of the cold cathode fluorescent lamp 10. Therefore, the adapter 100 can prevent the end part of the lamp body 11 and the lead terminal 12 of the cold cathode fluorescent lamp 10 from being pressed against the adapter 100 sandwiched by the contact 200 due to thermal expansion or from being ripped from the sandwiched adapter 100 due to thermal contraction. Consequently, the adapter 100 can reduce load applied to the cold cathode fluorescent lamp 10 during thermal expansion or thermal contraction.

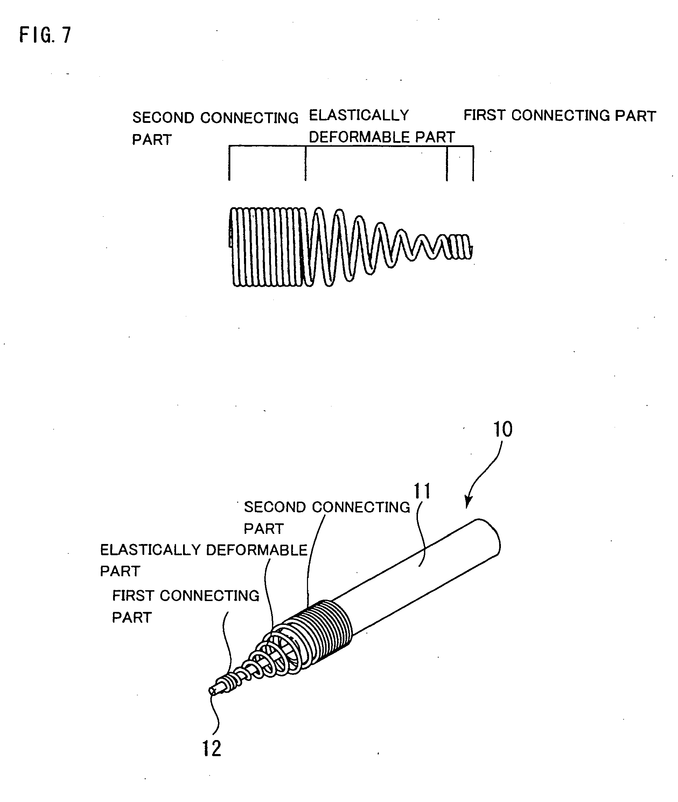

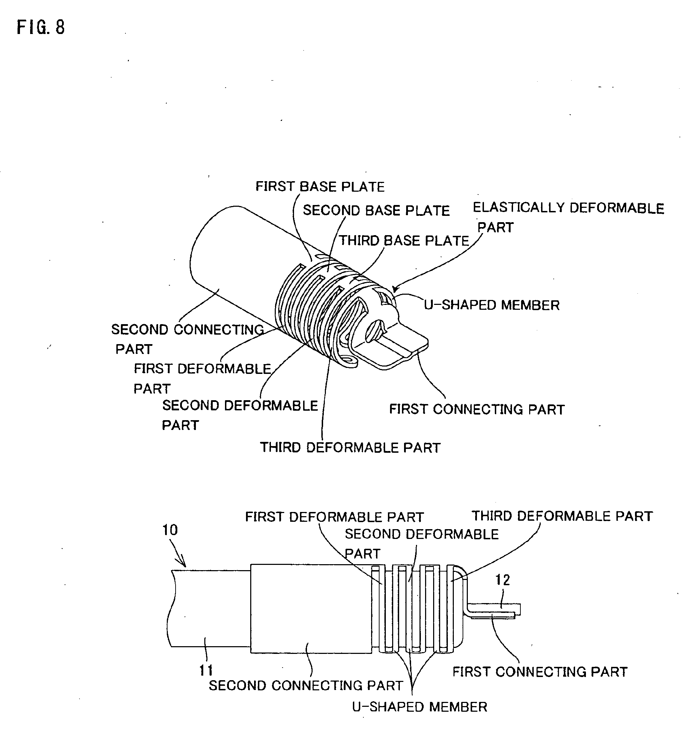

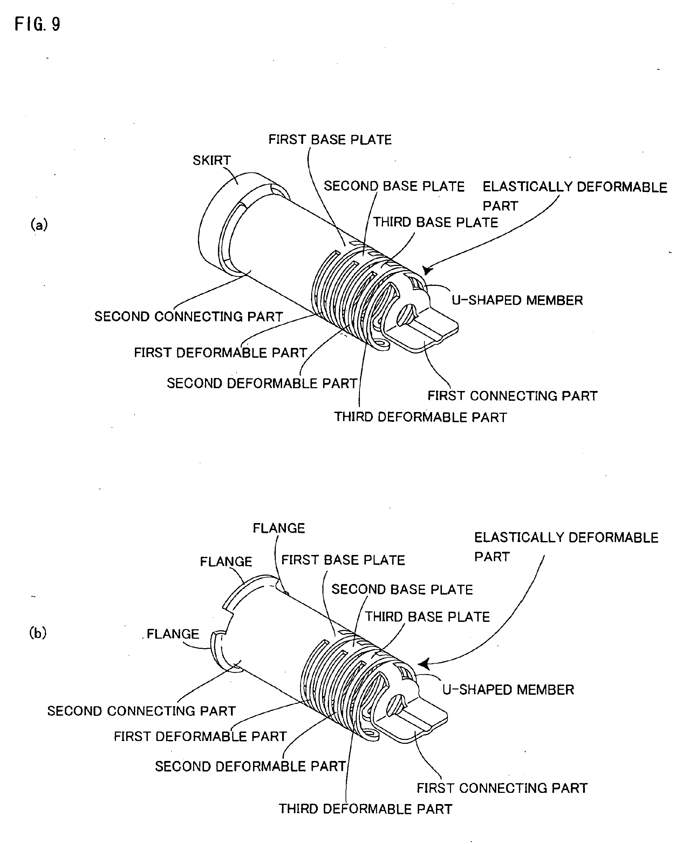

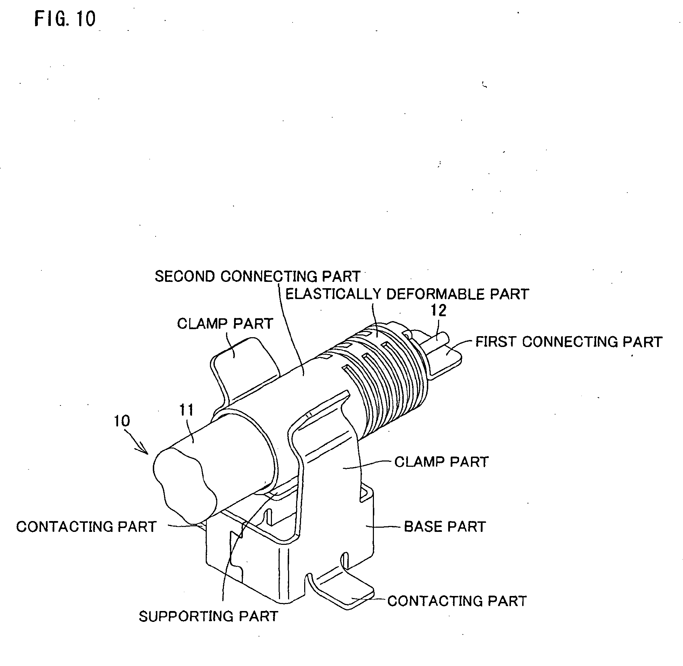

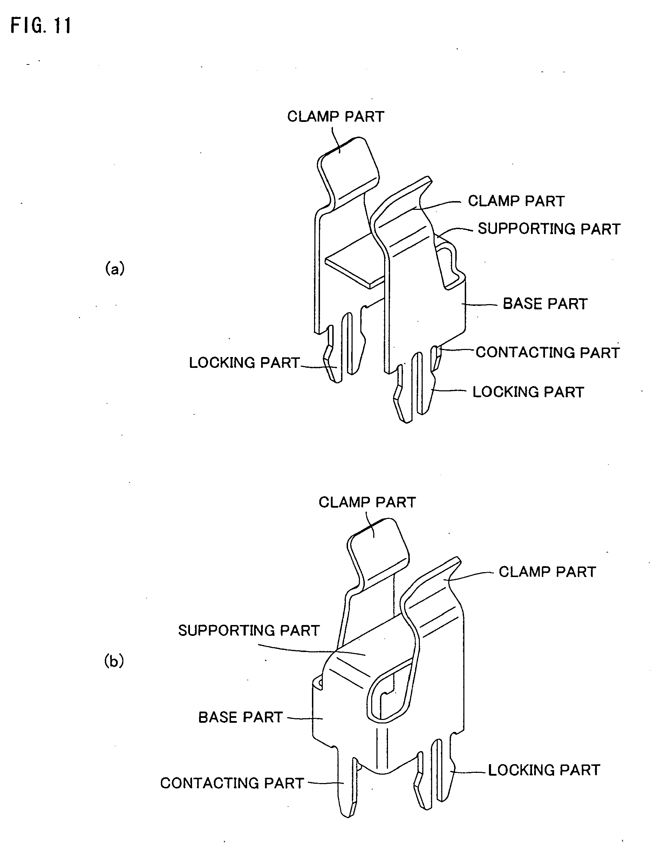

It is to be noted that the connecting device may be modified as long as it conforms to the gist of the claims. Each design modification example is given below in detail. Fig. 7 illustrates a first design modification example of the adapter, wherein Fig. 7(a) is a side view, and Fig. 7(b) is a perspective view of a state where the adapter is connected to the cold cathode fluorescent lamp, Fig. 8 illustrates a second design modification example of the adapter, wherein Fig. 8 (a) is a perspective view, and Fig. 8(b) is a side view of a state where the adapter is connected to the cold cathode fluorescent lamp, Fig. 9 (a) is a perspective view illustrating a third design modification example of the adapter, and Fig. 9(b) is a perspective view illustrating a fourth design modification example of the adapter, Fig. 10 is a perspective view illustrating a first design modification example of the contact in a state where the adapter and the cold cathode fluorescent lamp are connected to each other, and Fig. 11 is perspective views illustrating a second design modification example of the contact, wherein Fig. 11(a) is a view seen from a front upper side, and Fig. 11(b) is a view seen from a back upper side.

The above-described adapter can be modified as appropriate as long as it includes a first connecting part electrically and mechanically connectable to the lead thermal of the electronic component, a second connecting part arranged so as to face the end part of the main body of the electronic component, and an elastically deformable part provided between the first and second connecting parts and elastically deformable in accordance with thermal expansion or thermal contraction in the length direction of the electronic component.

For example, as illustrated in Fig. 7, the adapter may be a coil spring of a different type from that of the above-described embodiment-particularly, a type in which the first connecting part is a cylindrical coil body and the elastically deformable part is a conical coil body. Alternatively, the adapter may be formed from a press-molded metal plate having conductivity as illustrated in Fig. 8.

In the latter adapter, the first connecting part is a plate body having a substantially L shape in cross-sectional view and provided at its center with an insertion hole for receiving the lead terminal, the second connecting part is curved into a cylindrical shape so that its end surfaces are opposed to each other, and the elastically deformable part is provided between the first and second connecting parts. The elastically deformable part has first, second, and third base plates, and first, second and third deformable parts. The first base part is provided continuously at a central end of the second connecting part. The second and third base parts are arranged in spaced relation to each other between the first base part and a base end of the first connecting part. The first deformable part has a pair of U-shaped members, each of which is provided between each end of the first base part and each end of the second base part. The second deformable part has a pair of U-shaped members, each of which is provided between each end of the second base part and each end of the third base part. The third deformable part has a pair of U-shaped members, each of which is provided between each end of the third base part and each end of the base end of the first connecting part. The U-shaped members are curved into semi-circular arc shapes and elastically deformable, so that their end parts may be displaced in directions close to each other or away from each other. That is, the elastic deformation of the U-shaped members absorb thermal expansion or thermal contraction of the electronic component. The adapter may be provided with a skirt as illustrated in Fig. 9(a), or a plurality of flanges as illustrated in Fig. 9(b), at a rear end of the second connecting part.

The contact can be changed in design as appropriate, as long as it is a contact for connecting an electronic component, including a base part, a supporting part provided on top of the base part for supporting a lead terminal of the electronic component, and at least two clamp parts provided on top of the base part so as to be located on respective outer sides of the supporting part, the clamp parts being adapted to sandwich the lead terminal of the electronic component between themselves and the supporting part.

The base part may be modified in any manner as long as it can be provided with a supporting part and at least two clamp parts. For example, as illustrated in Fig. 10, the base part may be a plate body having a substantially O shape in planer view, including a first plate from which the supporting part is extended, two second plates extending from the respective ends of the first plate body, bent toward the same direction and provided with the clamp parts extending upward, and two third plates extending from respective ends of the second plate bodies and bent in such a manner that their end surfaces are opposed to each other. This type of base part, a plate body having a substantially O shape in planar view, can also be stably set on the circuit board.

Also, the base part is not limited to a plate body. For example, the base part can be a pedestal made of plastics material or the like. It is also possible to use a portion of the base part as the supporting part. It is preferable that a lower face of the base part can abut the circuit board when the contacting part is connected to the circuit board, and/or when the locking part is locked in the circuit board, but the base part is not limited to this kind.

It is described above that the supporting part supports the second connecting part of the adapter, but it is not limited to this. Instead, the supporting part may support the lead terminal of the electronic component such as the cold cathode fluorescent lamp.

The clamp parts can be changed in design as appropriate, as long as they can sandwich the second connecting part of the adapter or the lead terminal of the electronic component such as the cold cathode fluorescent lamp between themselves and the supporting part. For example, the clamp parts can be circular arc plate bodies projected outward. Moreover, although it is described above that the contact has two clamp parts, a larger number of clamp parts may be used. For example, three clamp parts may be arranged in a staggered manner to sandwich the second connecting part or the lead terminal between themselves and the supporting part.

It is optional whether to provide the holding parts. Figs. 10 and 11 exemplify contacts with the holding parts omitted. Moreover, the holding parts can be changed in design as appropriate, as long as they are shaped so as to be able to sandwich the main body of the electronic component. For example, the holding parts may have the same shape as that of the clamp parts 230 to sandwich the main body of the electronic component supported by the supporting part together with the second connecting part of the adapter.

It is optional whether to provide the contacting part. More particularly, the base part may be directly connected to the circuit board or the like, or a signal line may be connected to the base part so as to connect the base part to the circuit board or the like through the signal line. Moreover, the contacting part may be changed in shape as appropriate, as long as it can be connected to the circuit board. For example, as illustrated in Fig. 10, each contacting part may be a plate body bent substantially at a right angle with respect to the outer end of the base part, allowing connection to a pattern on the circuit board. Moreover, the contacting part may be electrically and mechanically connected to the circuit board by soldering or other means, thereby serving as attaching means to the circuit board.

It is also optional whether to provide the locking part. The locking part can be changed in shape as appropriate, as long as it can be locked in the circuit board or the like. Accordingly, the locking part herein includes not only a male side such as a locking claw described above but also a female side such as a locking hole or a locking groove for locking a locking projection provided in the circuit board or the like.

The electronic component is not limited to the cold cathode fluorescent lamp described above. The main body and the lead terminal of the electronic component are not limited to cylindrical shapes. Note that the respective elements of the connecting device may take any shapes and may be arranged in any manner, as long as similar functions to those of the above-described embodiment can be realized.

## Claims

1. A contact (200) for connection with an electronic component (10), comprising:
a base part (210);
a supporting part (220), provided on top of the base part for supporting a lead terminal (12) of an electronic component, in use, and
at least two clamp parts (230), provided on top of the base part so as to be located on respective outer sides of the supporting part, the clamp parts being adapted to sandwich the lead terminal of the electronic component between themselves and the supporting part.

2. The contact (200) according to claim 1, wherein the base part (210) is a plate-like body of a substantially U shape in planar view or a substantially O shape in planar view, the base part including a first plate and two second plates continuous with respective ends of the first plate and bent toward the same direction,
the supporting part (220) is a plate-like body extending from an upper end of the first plate and being bent toward the same direction as the second plates, and
the clamp parts (230) are a plate-like body extending upward from respective upper ends of the second plates.

3. The contact (200) according to claim 2 adapted to be mounted on a circuit board (20), the contact further comprising:
at least one of a contacting part (250) and a locking part (260), the contacting part being a plate-like body extending downward from a lower end of the base part (210) and adapted to be connectable to a circuit board, in use, the locking part (260) being a plate-like body extending downward from the lower end of the base part and adapted to be lockable in the circuit board, in use,
wherein a lower end face of the base part is abuttable against the circuit board, in at least one of states where the contacting part is connected to the circuit board and where the locking part is locked in the circuit board.

4. The contact (200) according to claim 2 adapted to be mounted on a circuit board (20), the contact further comprising:
a contacting part (250), being a plate-like body extending downward from a lower end of the first plate of the base part (210) and being connectable to a circuit board, in use; and
a locking part (260), being a plate-like body extending downward from a lower end of one of the second plates of the base part and being lockable in a circuit board, in use,
wherein a lower end face of the base part abuts the circuit board when the contacting part is connected to the circuit board and the locking part is locked in the circuit board.

5. The contact (200) according to claim 2, wherein the clamp parts (230) include:
abutting parts (232), bent inward and adapted, in use, to sandwich a lead terminal (12) of an electronic component (10) between themselves and the supporting part (220) by elastically abutting the lead terminal, and
inclined parts (233), continued from upper ends of the abutting parts and inclined outward, and
a distance between upper ends of the inclined parts is larger than a width dimension of the lead terminal of the electronic component, and a distance between tops of the abutting parts is smaller than the width dimension of the lead terminal.

6. A connecting device for connection with an electronic component (10), the electronic component having a main body (11) and a lead terminal (12) provided on an end part of the main body and extending in a length direction of the main body, the connecting device comprising:
an adapter (100) for connection with the electronic component; and
a contact (200) according to any one of claims 2 to 4, connectable to the electronic component via the adapter,
the adapter including:
a first connecting part (110), electrically and mechanically connectable to the lead terminal of the electronic component;
a second connecting part (120), arranged so as to face the end part of the main body of the electronic component; and
an elastically deformable part (130), provided between the first and second connecting parts and elastically deformable in accordance with thermal expansion or thermal contraction in the length direction of the electronic component,
wherein a supporting part (220) of the contact is adapted to support the second connecting part, instead of the lead terminal of the electronic component, and
clamp parts (230) of the contact are adapted to sandwich the second connecting part, instead of the lead terminal of the electronic component, between themselves and the supporting part.

7. A connecting device for connection with an electronic component (10), the electronic component having a main body (11) and a lead terminal (12) provided on an end part of the main body and extending in a length direction of the main body, the connecting device comprising:
an adapter (100) for connection with the electronic component; and
a contact (200) according to claim 5, connectable to the electronic component via the adapter,
the adapter including:
a first connecting part (110), electrically and mechanically connectable to the lead terminal of the electronic component;
a second connecting part (120), arranged so as to face the end part of the main body of the electronic component; and
an elastically deformable part (130), provided between the first and second connecting parts and elastically deformable in accordance with thermal expansion or thermal contraction in the length direction of the electronic component, wherein
a supporting part (220) of the contact is adapted to support the second connecting part, instead of the lead terminal of the electronic component,
abutting parts (232) of clamp parts (230) of the contact are adapted to abut the second connecting part, instead of the lead terminal of the electronic component, so as to sandwich the second connecting part between themselves and the supporting part,
the distance between upper ends of inclined parts (233) of the contact is larger than a width dimension of the second connecting part, and
the distance between the tops of the abutting parts is smaller than the width dimension of the second connecting part.

8. The connecting device according to claim 6 or claim 7,
the contact (200) further comprising at least two holding parts (240), the holding parts extending upward from upper ends of second plates of the base part (210) of the contact and being adapted to sandwich the end part of the main body (11) of the electronic component (10).

9. The connecting device according to claim 8,
the holding parts (240) each comprising:
a holding body (242), bent outward conforming to an outer shape of the main body (11) of the electronic component (10), and
an inclined portion (243), continuous to an upper end of the holding body and inclined outward,
wherein a distance between upper ends of the inclined portions is larger and a distance between lower ends of the inclined portions is smaller than a width dimension of the main body of electronic component.

10. The connecting device according to claim 6 or claim 7,
wherein the second connecting part (120) of the adapter (100) is an annular body adapted to receive the end part of the main body (11) of the electronic component (10).
